# EUROPÄISCHE PATENTSCHRIFT

(11) **EP 0 331 925 B1**
(45) Veröffentlichungstag und Bekanntmachung des Hinweises auf die Patenterteilung: **28.07.1993**
(21) Anmeldenummer: 89102292.3
(22) Anmeldetag: 10.02.1989
(51) Int. Cl.: H03H 7/46

(54) **Frequenzweiche**
Branching filter
Filtre d'aiguillage

(30) Priorität: 10.03.1988 DE 3807912
(43) Veröffentlichungstag der Anmeldung: 13.09.1989
(73) Patentinhaber: RICHARD HIRSCHMANN GMBH & CO., 73726 Esslingen (DE)
(72) Erfinder: Blind, Manfred, D-7000 Stuttgart 70 (DE); Wendel, Wolfgang, D-7316 Köngen (DE)
(74) Vertreter: Stadler, Heinz, Dipl.-Ing.

(56) Entgegenhaltungen:
- DE-A- 2 238 716
- US-A- 3 771 064

## Beschreibung

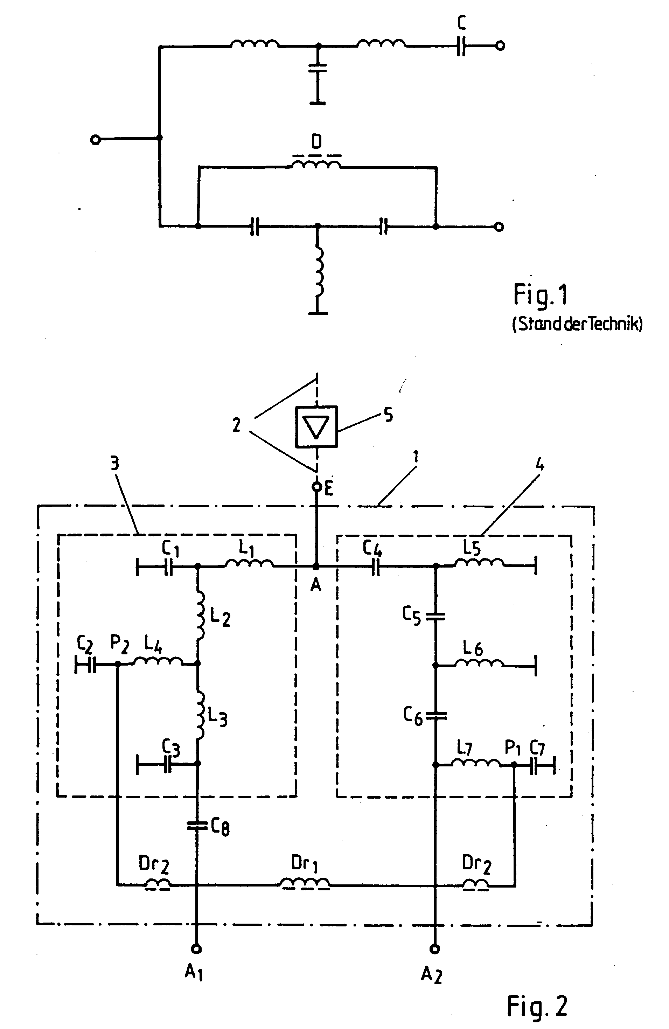

Die Erfindung betrifft eine Frequenzweiche gemäß dem Oberbegriff des Anspruches 1. Eine derartige Frequenzweiche ist z.B. durch das Gerät "Wak 202" der Anmelderin bekannt, deren Prinzipschaltung in Figur 1 dargestellt ist. Bei solchen Hoch-/Tiefpaß-Weichen wäre an sich die Fernspeisung über den Tiefpaß-Zweig ohne zusätzliche Schaltmittel möglich. In manchen Fällen wird jedoch der Fernspeisestrom im weiteren Leitungszug des Hochpaß-Zweiges angeliefert bzw. benötigt. Zu diesem Zweck ist dann gemäß Figur 1 das Längsglied des Hochpaß-Zweiges durch eine Drossel D überbrückt und im Längszweig des Tiefpasses eine Trennkapazität C vorgesehen.
Diese mit geringem Aufwand fernspeisetauglich gemachte bekannte Frequenzweiche funktioniert im VHF-Bereich zufriedenstellend. Bei hohen Frequenzen ab dem UHF-Bereich wirken sich jedoch die Windungs- und Streukapazitäten der Drossel nachteilig auf die Übertragungseigenschaften des Hochpaß-Zweiges aus: Die Durchgangsdämpfung wird größer, die Rückflußdämpfung und die Koppeldämpfung geringer, die Sperrwirkung in diesem Zweig für die Frequenzen des über den Tiefpaß-Zweig übertragenen Bereichs verschlechert.
Diese Nachteile werden mit höheren Speiseströmen (und damit größerem Drahtdurchmesser der Drossel) und/oder wachsenden Frequenzen gravierender. Bei dem mit wachsender Anzahl von Satelliten-Empfangsanlagen immer häufiger werdenden Einsatz von Weichen im ersten Satelliten-Zwischenfrequenzbereich, über die z.B. aus dem beim Fernsehempfänger angeordneten Satellitentuner Verstärker fernzuspeisen sind, ist die bekannte Schaltung aus dem genannten Grund meist nicht mehr brauchbar.

Der Erfindung liegt daher die Aufgabe zugrunde, eine Frequenzweiche gemäß dem Oberbegriff des Anspruches 1 derart weiterzubilden, daß auf einfache und kostengünstige Weise auch bei hohen Frequenzen und Speiseströmen die Fernspeisemittel nur eine möglichst geringe Verschlechterung der Hochfrequenz-Übertragungseigenschaften der Frequenzweiche verursachen.

Diese Aufgabe ist durch die Merkmale des Anspruches 1 gelöst.
Durch die Führung des Fernspeisestroms von einem "hochfrequenzmäßig kalten" Schaltungspunkt des Zweiges für eine höhere Frequenz über die Drossel und wenigstens eine Induktivität des Zweiges für eine tiefere Frequenz ist die Beeinflussung der Hochfrequenzkreise der Frequenzweiche gegenüber dem Stand der Technik entscheidend verringert. Dadurch werden ihre Hochfrequenz-Übertragungseigenschaften selbst bei den hohen Frequenzen des ersten Satelliten-Zwischenfrequenzbereiches und bei hohen Speiseströmen nur unwesentlich verschlechtert.
Dabei ist mit dem Blockkondensator lediglich ein einziges zusätzliches Bauteil und somit ein äußerst geringer Mehraufwand erforderlich.
Wenn die Frequenzweiche mehrere Zweige für die Übertragung unterschiedlicher Frequenzbereiche aufweist, so ist die maximale Wirkung der erfindungsgemäßen Maßnahme dann erreicht, wenn der Zweig für den höchsten Frequenzbereich mit demjenigen für den tiefsten Frequenzbereich auf die im Anspruch 1 angegebene Weise zusammengeschaltet werden.

In den Unteransprüchen sind vorteilhafte Weiterbildungen der erfindungsgemäßen Frequenzweiche beschrieben.
So ist durch eine Ausgestaltung nach Anspruch 2 auf einfache Weise eine Doppelnutzung des Blockkondensators erreicht. Dies ist selbstverständlich auch dann der Fall, wenn - wie es in der Praxis häufig vorkommt-der Querinduktivität zur Flankenversteilerung der Übertragungskennlinie bereits ein Kondensator in Serie geschaltet ist. Dann kann dieser zugleich als Blockkondensator zur Vermeidung eines Kurzschlusses für den Speisestrom mitbenutzt werden, so daß der erfindungsgemäße Vorteil ohne jeglichen Mehraufwand erreicht ist.

Ist im niederfrequenten Zweig nur eine einzige Längsinduktivität vorgesehen, so liegt die Fernspeisespannung direkt am Zweiganschluß an, so daß die Entkopplung zwischen den Anschlüssen der beiden Zweige für einen höheren und einen tieferen Frequenzbereich nicht optimal, sondern gegenüber einer ansonsten gleichen Frequenzweiche ohne Fernspeisung geringer ist. Diese Verschlechterung der Koppeldämpfung zwischen den genannten Anschlüssen läßt sich auf einfache Weise dadurch vermeiden, daß im Zweig für den tieferen Frequenzbereich mindestens zwei Längsspulen vorgesehen sind und gemäß Anspruch 3 der Fernspeiseanschluß über möglichst gleich viele Längsinduktivitäten mit dem Auftrenn- bzw. Zusammenschaltpunkt der Frequenzweiche einerseits und dem Anschlußpunkt dieses Zweiges andererseits verbunden ist. Bei geradzahliger Spulenanzahl ist diese Aufteilung exakt realisierbar. Bei ungeradzahliger Anzahl von Längsinduktivitäten gilt dies jedoch nur, wenn eine Mittelanzapfung der mittleren Spule möglich ist; andernfalls ist es zumeist günstiger, den Fernspeiseanschluß zwischen der mittleren und der zum Zweiganschlußpunkt hin nächstfolgenden Spule vorzusehen.

Durch einen Schaltungsaufbau nach Anspruch 4 ist in vorteilhafter Weise der störende Einfluß der Streukapazität der Drossel auf die Übertragungseigenschaften im tieferen Frequenzbereich, insbesondere deren Rückflußdämpfung spürbar vermindert. Wird dabei die Kapazität nicht nur als Blockkondensator, sondern durch entsprechende Bemessung zusammen mit der Streukapazität der Drossel zugleich zur Versteilerung der Filterflanken im tieferen Frequenzbereich benutzt, so ist mit geringstmöglichem Aufwand eine Mehrfachnutzung dieses Bauteils erreicht.

Eine Ausführung der Fernspeise-Drossel gemäß Anspruch 5 bedeutet zwar einen geringfügig höheren Herstellungsaufwand, dafür ist jedoch die Windungskapazität geringer als bei einer einzigen großen Drossel und damit wunschgemäß der die Entkopplung der beiden Zweiganschlüsse mindernde Einfluß wesentlich herabgesetzt. Außerdem ist durch die kleineren Teildrosseln die die Güte eines zur Flankenversteilerung als Querglied im Zweig für den höheren Frequenzbereich eingeschalteten Serienresonanzkreises verschlechternde Wirkung spürbar verringert.

In der Regel stellt eine Aufteilung in drei Teildrosseln mit einer größeren mittleren und zwei kleineren Teildrosseln zu den Zweiganschlüssen hin einen besonders günstigen Kompromiß zwischen Aufwand und elektrischer Wirkung dar. Sofern die Frequenzbereiche der beiden Zweige nicht sehr stark unterschiedlich sind, können im Hinblick auf eine kostengünstige Mengenfertigung die beiden kleineren Teildrosseln gleich ausgeführt werden. Liegen jedoch die Frequenzbereiche der beiden Zweige sehr weit auseinander, so ist es zweckmäßig, diese beiden kleineren Teildrosseln unterschiedlich auszuführen, wobei diejenige mit der geringeren Induktivität zu dem Zweig für den höheren Frequenzbereich hin anzuordnen ist.

Die Erfindung wird mittels der Zeichnungen näher beschrieben. In Figur 1 ist eine Fernspeiseweiche nach dem Stand der Technik dargestellt.

In Figur 2 ist ein Schaltbild eines Ausführungsbeispiels der erfindungsgemäßen Frequenzweiche in einer Anwendung als Antennen-Endsteckdose zum Einsatz in einer Gemeinschaftsanlage für die Übertragung terrestrischer und Satelliten-Rundfunksignale dargestellt.

Die Frequenzweiche 1 der Antennen-Endsteckdose ist am empfängerseitigen Ende einer Stammleitung 2 am Auftrennpunkt A an diese angeschlossen und besteht aus einem Tiefpaß 3 für den Frequenzbereich bis 860 MHz (terrestrisches Fernsehen), der am Anschluß A₁ zu einem Fernsehgerät weitergeführt wird, sowie einem Hochpaß 4 für den Frequenzbereich ab 950 MHz (erster Satelliten-Zwischenfrequenzbereich), der am Anschluß A₂ (ursprünglich rechtszirkular polarisierte Satellitensignale) zu einem am Fernsehgerät angeschlossenen Satellitentuner weitergeführt wird. Der Tiefpaß 3 besteht aus drei Längsinduktivitäten L₁, L₂, L₃ und entsprechend drei gegen Masse geschalteten Querkapazitäten C₁, C₂, C₃. Das mittlere Querglied enthält zur Versteilerung der Filterflanke am oberen Ende des UHF-Bereichs eine zwischen der Kapazität C₂ und dem Verbindungspunkt der Induktivitäten L₂ und L₃ eingeschaltete Induktivität L₄. Der Hochpaß 4 besteht analog zum Tiefpaß 3 aus drei Längskapazitäten C₄, C₅, C₆ und drei Querinduktivitäten L₅, L₆, L₇. Die mit dem Anschluß A₂ direkt verbundene Querinduktivität L₇ ist durch eine gegen Masse geschaltete Kapazität C₇ zu einem Reihenresonanzkreis zur Versteilerung der Filterflanke am unteren Ende des ersten Satelliten-Zwischenfrequenzbereichs ergänzt.

Der Zusammenschaltpunkt P₁ der Querinduktivität L₇ und der Kapazität C₇ des Hochpasses 4 ist über eine Drossel Dr₂ mit kleinerer Induktivität, einer Drossel Dr₁ mit größerer Induktivität und einer weiteren Drossel Dr₂ mit dem die Querinduktivität L₄ und die Kapazität C₂ des Tiefpasses 3 verbindenden Schaltungspunkt P₂ verbunden.
Ein aus dem Satellitentuner gelieferter Fernspeisegleichstrom wird über den Steckdosenanschluß A₂ für die ursprünglich rechtszirkular polarisierten Satellitensignale, die Querinduktivität L₇, die Drosseln Dr₂, Dr₁ und wiederum Dr₂ sowie die Induktivitäten L₄, L₂, L₁, den HF-Eingang E der Frequenzweiche 1 und die Stammleitung 2 einem Verstärker 5 zu dessen Betriebsstromversorgung zugeführt.
C₇ bewirkt durch entsprechende Bemessung zugleich eine Abblockung des Fernspeisegleichstroms sowie zusammen mit der Streukapazität insbesondere der am Zusammenschaltpunkt P₁ angeschlossenen Drossel Dr₂ und der Induktivität L₇ die bereits angeführte Flankenversteilerung des Hochpasses 4. Entsprechend wirkt C₂ einerseits als Blockkondensator und ergibt zum anderen zusammen mit der Streukapazität insbesondere der am Schaltungspunkt P₂ angeschlossenen Drossel Dr₂ und der Induktivität L₄ die angestrebte Flankenversteilerung beim Tiefpaß 3.
C₁ ist ebenfalls als Blockkondensator wirksam, C₄ verhindert einen Kurzschluß des Fernspeisegleichstroms über L₅ und C₈ dessen Abfließen über den Anschluß A₁.

Durch die beschriebene Führung des Fernspeisegleichstroms über die Frequenzweiche ist auf äußerst einfache und kostengünstige Weise erreicht, daß die Hochfrequenz-Übertragungseigenschaften der Frequenzweiche durch den mitübertragenen Fernspeisegleichstrom praktisch nicht merklich verschlechtert sind.

Bei einer analogen Antennen-Endsteckdose zum Empfang ursprünglich linkszirkular polarisierter Satellitensignale sowie des terrestrischen Tonrundfunks kann die Schaltung der erfindungsgemäßen Frequenzweiche in gleicher Weise ausgeführt werden, wobei lediglich die Induktivität der beiden Teildrosseln Dr₂ ungleich zu bemessen und deren kleinere am Zusammenschaltpunkt P₁ anzuschließen ist.

## Patentansprüche

1. Frequenzweiche zum Trennen eines Gesamtfrequenzbereiches in zwei Teilfrequenzbereiche bzw. deren Zusammenschaltung, über die zur Betriebsstromversorgung eines aktiven Bauteils ein Fernspeisestrom in den Anschlußpunkt eines Zweiges für einen höheren Teilfrequenzbereich eingespeist wird, wobei dieser Zweig zumindest eine Längskapazität und eine an seinem Anschlußpunkt angeschlossen Querinduktivität aufweist,
dadurch gekennzeichnet, daß die am Anschlußpunkt (A₂) des Zweiges (4) für einen höheren Frequenzbereich angeschlossene Querinduktivität (L₇) über einen Blockkondensator (C₇) an Masse liegt und der Zusammenschaltpunkt (P₁) dieser beiden Blindwiderstände (L₇, C₇) über eine Drossel (Dr₁, Dr₂) mit einem Schaltungspunkt (P₂) eines Zweiges (3) für einen tieferen Teilfrequenzbereich verbunden ist, der über mindestens eine Induktivität (L₁, L₂, L₄) am Auftrennpunkt (A) bzw. Zusammenschaltpunkt der Frequenzweiche (1) angeschlossen ist.

2. Frequenzweiche nach Anspruch 1, dadurch gekennzeichnet, daß der Blockkondensator (C₇) so bemessen ist, daß er zusammen mit der zu ihm in Serie geschalteten Querinduktivität (L₇) und der Streukapazität der Drossel (Dr₂) eine Flankenversteilerung der Filtercharakteristik des Zweiges (4) für einen höheren Frequenzbereich bewirkt.

3. Frequenzweiche nach Anspruch 1 oder 2 mit mindestens zwei Längsinduktivitäten in dem einen Zweig (3) für einen tieferen Frequenzbequenzbereich, dadurch gekennzeichnet, daß der Schaltungspunkt (P₂) über möglichst gleich viele Längsinduktivitäten (L₁, L₂, L₄ bzw. L₃, L₄) mit dem Auftrennpunkt (A) bzw. Zusammenschaltpunkt der Frequenzweiche (1) einerseits und dem Anschlußpunkt (A₁) dieses Zweiges (3) andererseits verbunden ist.

4. Frequenzweiche nach einem der Ansprüche 1 bis 3, dadurch gekennzeichnet, daß der Zweig (3) für einen tieferen Frequenzbereich wenigstens ein als Serienresonanzkreis ausgebildetes Querglied aufweist, dessen Induktivität (L₄) am Längsglied angeschlossen ist und dessen Kapazität (C₂) an Masse liegt, und daß der Verbindungspunkt dieser Blindwiderstände (L₄, C₂) den Schaltungspunkt (P₂) bildet.

5. Frequenzweiche nach einem der Ansprüche 1 bis 4, dadurch gekennzeichnet, daß die Drossel aus wenigstens zwei unterschiedliche Induktivitäten aufweisenden Teildrosseln (Dr₁, Dr₂) besteht und die Teildrossel (Dr₂) mit der kleineren Induktivität am Zweig (4) für einen höheren Frequenzbereich angeschlossen ist.

## Claims

1. Branching filter for dividing a total frequency range into two partial frequency ranges or, respectively, for switching them together, which is used to feed a supply current from a distance into the connection point of a branch for a higher partial frequency range, wherewith this branch possesses at least one capacitor in series and one transverse inductance connected to its connection point,
in such a way characterised, that the transverse inductance (L₇) that is connected to the connection point (A₂) of the branch (4) for a higher partial frequency range is grounded via a block capacitor (C₇) and that the interconnection point (P₁) of these two reactances (L₇, C₇) is connected by way of a choking coil (Dr₁, Dr₂) to a circuit point (P₂) of a branch (3) for a lower partial frequency range that is connected by way of at least one inductance (L₁, L₂, L₄) to the separation point (A) or, respectively, the interconnection point of the frequency branching filter (1).

2. Branching filter according to claim 1, in such a way characterised, that the block capacitor (C₇) is sized in such a way that in combination with the transverse inductance (L₇) connected in series and the parasitic capacity of the choking coil (Dr₂), it leads to an increase of the flank steepness of the filter characteristics of the branch (4) for a higher partial frequency range.

3. Branching filter according to claim 1 or 2 with at least two inductances in series in the one branch (3) for a lower partial frequency range, in such a way characterised, that the circuit point (P₂) is connected by way of an equal number, if possible, of inductances in series (L₁, L₂, L₄ or L₃, L₄, respectively) to the separation point (A) or, respectively, the interconnection point of the frequency branching filter (1) on the one hand and the connection point (A₁) of this branch (3) on the other hand.

4. Branching filter according to one of the claims 1 to 3, in such a way characterised, that the branch (3) for a lower partial frequency range possesses at least one transverse element that is designed to act as a resonance circuit in series and whose inductance (L₄) is connected to the element in series and whose capacity (C₂) is connected to ground, and that the interconnection point of these two reactances (L₄, C₂) forms the circuit point (P₂).

5. Branching filter according to one of the claims 1 to 4, in such a way characterised, that the choking coil consists of at least two partial choking coils (Dr₁, Dr₂) with different inductances and that the partial choking coil (Dr₂) with the lower inductance is connected to the branch (4) for a higher partial frequency range.

## Revendications

1. Filtre d'aiguillage pour séparer une gamme de fréquence totale en deux gammes des fréquences partielles ou, respectivement, pour les interconnecter, qui sert à alimenter par distance un courant de service dans le point de connexion d'une branche d'une gamme des fréquences plus hautes, cette branche possédant au moins une capacité en série et une inductance transversale raccordées au point de connexion,
caractérisé par les faits que l'inductance transversale (L₇) qui est connectée au point de connexion (A₂) de la branche (4) pour la gamme partielle des fréquences plus hautes est connectée à terre par un condensateur de blocage (C₇) et que le point d'interconnexion (P₁) de ces deux réactances (L₇, C₇) est connecté par une bobine de réactance (Dr₁, Dr₂) à un point de circuit (P₂) d'une branche (3) d'une gamme partielle des fréquences plus basses qui est connecté par au moins une inductance (L₁, L₂, L₄) au point de séparation (A) ou, respectivement, le point d'interconnexion du filtre d'aiguillage fréquence (1).

2. Filtre d'aiguillage comme en demande 1, caractérisé par les faits que le condensateur de blocage (C₇) est dimensionné tant que en combinaison avec l'inductance transversale (L₇) connectée en série et avec la capacité parasitaire de la bobine de réactance (Dr₂) il cause un accroissement de la pente du flanc des caractéristiques filtre de la branche (4) pour la gamme partielle des fréquences plus hautes.

3. Filtre d'aiguillage selon demandes 1 ou 2 avec au moins deux inductances en série dans la branche (3) pour la gamme partielle des fréquences plus basses, caractérisé par les faits que le point d'interconnexion (P₂) est connecté, si possible, par le même nombre des inductances en série (L₁, L₂, L₄ ou L₃, L₄, respectivement) avec le point de séparation (A) ou, respectivement, le point d'interconnexion du filtre d'aiguillage (1) dans une coté et le point de connexion (A₁) de cette branche (3) dans l'autre coté.

4. Filtre d'aiguillage selon une des demandes 1 à 3, caractérisé par les faits que la branche (3) pour la gamme partielle des fréquences plus basses possède au moins un élément transverse désigné comme circuit de résonance en série, l'inductance (L₄) étant connectée à l'élément en série et sa capacité (C₂) étant connectée à la terre, et que le point d'interconnexion de ces deux réactances (L₄, C₂) constitue le point de circuit (P₂).

5. Filtre d'aiguillage selon une des demandes 1 à 4, caractérisé par les faits que la bobine de réactance consiste au moins de deux bobines de réactance partielles (Dr₁, Dr₂) avec des inductances différentes et que la bobine de réactance partielle (Dr₂) ayant l'inductance plus basse est connecté à la branche (4) pour la gamme partielle des fréquences plus haute.
